# EUROPEAN PATENT SPECIFICATION

(11) **EP 0 301 761 B1**
(45) Date of publication and mention of the grant of the patent: **24.05.1995**
(21) Application number: 88306682.1
(22) Date of filing: 21.07.1988
(51) Int. Cl.: H01L 29/74, H01L 29/32

(54) **Thyristors**
Thyristoren
Thyristors

(30) Priority: 25.07.1987 GB 8717695
(43) Date of publication of application: 01.02.1989
(73) Proprietor: PLESSEY SEMICONDUCTORS LIMITED, Swindon, Wiltshire SN2 2QW (GB)
(72) Inventor: Crees, David Edward, Welton Lincoln LN2 3ND (GB); Frith, Peter John, Edinburgh EHB 9PP (GB); Plumpton, Ashley Terry, Lincoln (GB); Courtney, David Francis, Atherton Manchester (GB)
(74) Representative: Cockayne, Gillian

(56) References cited:
- FR-A- 2 144 581
- US-A- 4 165 517
- US-A- 4 314 266
- PATENT ABSTRACTS OF JAPAN, vol. 8, no. 272 (E-284)[1709], 13th December 1984 ; & JP-A-59 141 269
- INTERNATIONAL ELECTRON DEVICES MEETING, Washington, DC, 7th-9th December 1981, pp. 406-409, IEEE, New York, US ; V.A.K. TEMPLE : "Controlled thyristor turn-on for high DI/DT capability"
- PATENT ABSTRACTS OF JAPAN, vol. 14, no. 120 (E-899)[4063], 6th March 1990 ; & JP-A-1 316 973

## Description

This invention relates to thyristors, and more particularly to the protection of thyristors during adverse turn-on conditions prior to the "recovery time".

A thyristor is turned on by application of a current pulse to a gate electrode. This results in the emitter-base junction at the cathode becoming forward biased and conduction occurring through the device in a bulk conducting volume between the main cathode and the anode, this being known as forward conduction. Thyristor turn-off and subsequent "recovery" is achieved by applying a reverse bias across the anode and cathode electrodes of the device to reduce current flow below the thyristor holding level. The current flow through the thyristor first decreases to zero (known as current zero) and then becomes negative as charge carriers in the device are extracted, and as the depletion layer of the reverse blocking junction forms. At current zero the device still contains charge carriers in its base regions, which cannot be removed easily once the depletion layer of the blocking junction forms. Such charge carriers recombine at a rate determined by the carrier lifetimes of the base regions.

If a positive voltage ramp is now applied across the thyristor at some time after current zero, a displacement current is generated, which has a magnitude determined by the rate of rise of the voltage ramp and the forward junction capacitance. If the voltage across the device reaches zero volts, any unrecombined charge begins to flow from the base regions: the sum of the extracted unrecombined charge current and the displacement current is collectively known as the forward recovery current and can trigger the thyristor back into a forward conduction state. Importantly, the magnitude of this current depends on the amount of unrecombined charge still remaining in the base regions of the thyristor at the time of application of the positive voltage ramp and the rate of rise of the voltage ramp. If the forward recovery current is small the thyristor is not turned on, and the voltage across the thyristor continues to rise. However, the forward recovery current may be large enough to cause the base-emitter junction to become sufficiently forward biased as to turn-on the thyristor. If a large amount of unrecombined charge still exists in the base regions when the voltage ramp is applied, turn-on occurs fairly uniformly across the thyristor. In this case, the relatively low energy dissipation density results in the thyristor being turned on non-destructively. However, a problem may arise when a positive voltage is applied at a time after curent zero when only a few unrecombined carriers still remain in the base regions of the device. In this situation, turn-on may occur in only a small volume of the thyristor, whereby the energy dissipated could cause the small initial turned-on region to become so hot that the device is destroyed. This may happen even where the rate of rise of the voltage ramp is relatively small. For a given positive voltage ramp condition, the minimum time between current zero and the point where zero voltage appears across the thyristor such that turn-on does not occur, is known as the "thyristor recovery time".

Previous methods for preventing damage to the thyristor during such adverse turn-on conditions, when a voltage is reapplied shortly after applying a reverse bias but prior to the end of the thyristor recovery time, have employed expensive external circuitry to monitor the positive ramp voltage to be applied and bias on the device conventionally before damage can occur. However, such circuitry is complex and potentially unreliable.

Japanese patent application JP-A-59-141269 describes a method of protecting a thyristor under commutation failure through the use of an auxiliary thyristor whose carrier lifetime is longer than that of the main thyristor. By selecting the carrier lifetimes within auxiliary and main thyristor regions the relative on-state resistances of the two regions are selected such that the auxiliary thyristor continues to conduct in the normal on-state and then recovers after the main thyristor region to provide the protection.

Another problem that can occur is the false turn-on of the device when an excess anode-to-cathode voltage is applied, referred to as voltage breakover turn-on. The US patent application US 4,165,517 is concerned with protection against voltage breakover turn-on which is achieved by selective control of the minority charge carrier lifetime in the gate region, thereby establishing a predictable location of voltage breakover in the gate region.

The present invention seeks to provide a thyristor having improved protection against this adverse turn-on condition.

According to this invention, there is provided a thyristor comprising a region of relatively long carrier lifetime (12) compared to that of a bulk conducting volume, the region being located within approximately four carrier diffusion lengths from the bulk conducting volume such that, during conduction, sufficient charge carriers enter the region from the bulk conducting volume, whereby under adverse turn-on conditions prior to the end of the thyristor recovery time, initial turn-on occurs at the region. The location of the region and its geometrical dimensions must be carefully chosen for optimum performance. By including a region of relatively long carrier lifetime in accordance with the invention, it is possible to ensure that turn on is initiated in that region and thus that the thyristor is protected against destructive turn-on after conduction through the bulk conducting volume has reached current zero. It has been found that, advantageously, the relatively long carrier lifetime is approximately two or more times the carrier lifetime in the bulk conducting volume.

In previous devices, such adverse turn-on conditions in which a positive voltage ramp is applied a short time after current zero would have resulted in partial turn-on in the bulk conducting volume with possible damage. The application of such a voltage ramp at that time across a thyristor in accordance with the invention however, results in turn-on being initiated in the region of relatively long carrier lifetime, where enough unrecombined carriers exist to provide turn-on. In a preferred embodiment of the invention, an amplifying gate arrangement with integral current limiting resistors is used to prevent damage to the region and to allow the remainder of the thyristor to turn on.

The region is located close to the bulk conducting volume, within approximately four carrier diffusion lengths of it. However, this may not be an appropriate location because of design and/or manufacturing constraints. Advantageously therefore there may be included an intermediate zone of long carrier lifetime located between the region and the bulk conducting volume. Such an arrangement enables the long lifetime region in which initial turn-on occurs during adverse turn-on conditions to be positioned slightly further from the bulk conducting volume than would otherwise be practicable, since charge carriers entering the intermediate zone from the bulk conducting volume will exist for a sufficient time for them to cross the zone to the region where turn-on occurs. It has been found that the region should anyway be located within approximately four carrier diffusion lengths of the bulk conducting volume.

It is preferred that the region is such that a smaller charge carrier density than that of the bulk conducting volume is required for turn-on to occur. This may be achieved by arranging that the conduction path through the region is shorter than that through the bulk conducting volume. For example, an emitter region and metallisation layer at the region may be recessed into it to form a "well" configuration. The region is thus of high current gain.

Preferably, a current limiting resistor is included and arranged adjacent the region. The current flow through the initial turned-on area may then be restricted and damagingly high current densities prevented. Preferably, the region is surrounded by current limiting resistors.

Preferably, a plurality of regions of relatively long carrier lifetime are included. These may be distributed in such a way to give more uniform turn-on across the whole device. Also, by including a plurality of such regions, it is probable that at least one region is located adjacent to the last part of the main cathode to cease conduction, and thus that the charge carriers exist in that region for a maximum time after conduction has ceased.

According to an aspect of the invention, a method of manufacturing a thyristor in accordance with the invention includes masking part of a semiconductor body where it is desired to have a region of relatively long carrier lifetime and producing a greater density of damage sites in the unmasked portion than in the masked part. The damage sites could be produced by well established processing techniques such as electron irradiation. The carrier lifetime could alternatively be modified by using masked gold or platinum diffusion for example.

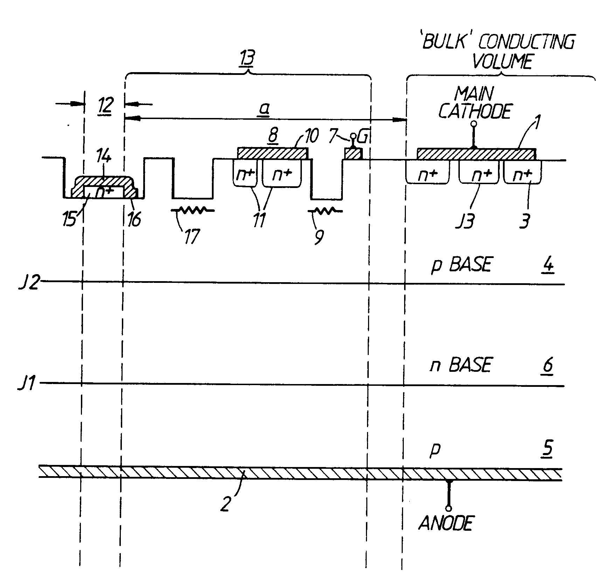

The invention is now further described by way of example with reference to the accompanying drawing, in which the sole figure schematically illustrates a thyristor in accordance with the invention.

With reference to the Figure, a thyristor includes a main cathode electrode 1 and an anode electrode 2 between which current flows during conduction through the device. An n-emitter region 3 is located adjacent the cathode electrode 1 and forms a junction J3 with a p-base region 4. A p-diffused anode region 5 is located adjacent the anode electrode 2 and an n-base region 6 lies between the two p-base regions 4 and 5.

To initiate conduction, a current is applied to a gate electrode 7 and flows through the p-base region 4 to the cathode 1. This current flow causes the junction J3 to become forward biased and electrons are injected into the p-base region 4 from the n-emitter region 3. The electrons are accelerated across a depletion layer associated with the junction J2 between the p-base region and the n-base region 6. Electrons diffuse through the n-base region 6 and cause hole injection from the p-base anode 5, and conduction occurs through the thyristor. It is desirable that the bulk conducting volume between the cathode 1 and the anode 2 has a relatively short carrier lifetime in the vicinity of the junction J2 between the p-base region 4 and the n-base region 6. Then, when reverse bias is applied across the thyristor to turn it off, there is relatively rapid recombination with a correspondingly short recovery time.

Following commutation of the thyristor, (i.e. when the bias is reversed), reverse recovery current flows until carriers have been excluded from the reverse blocking junction J1 and the depletion layer forms. Excess carriers remain in the base regions 4 and 6 and recombine at a rate determined by their lifetimes in these regions.

The thyristor includes an auxiliary thyristor 8 separated from the main cathode 1 by a current limiting resistor 9. The auxiliary thyristor 8 includes a metallisation layer 10 and an n-emitter region 11.

The thyristor also includes a long lifetime region indicated at 12 and located within about four carrier diffusion lengths from the bulk conducting volume between the main cathode 1 and anode 2 at a distance a. In the thyristor shown in the Figure, the n-base region 6 in the long lifetime region 12 is arranged to have a relatively long carrier lifetime, being approximately two times the carrier lifetime in the bulk conducting volume. An intermediate zone 13 which also has a long carrier lifetime is located between the region 12 and the bulk conducting volume, and in this embodiment has approximately the same carrier lifetime as region 12. The intermediate zone 13 is contiguous with the region 12 and less than one carrier diffusion length from the bulk conducting volume. A metallised surface layer 14 and an n-emitter region 15 are included at the long lifetime region 12 forming a higher gain thyristor structure which is connected, via a p-base short 16 and a current limiting resistor 17, to the auxiliary thyristor 8 which is located at the intermediate zone 13.

After current zero but prior to the end of the recovery time charge carriers recombine more slowly in the long lifetime region 12 and intermediate zone 13 than in the bulk conducting volume. Thus near to the end of the thyristor recovery time many unrecombined carriers still exist in region 12 and zone 13 whereas few remain within the bulk conducting volume. If a positive going voltage ramp is applied across the thyristor, so that it becomes forward biased, prior to the elapse of the thyristor recovery time, many holes flow through the p-base 4 beneath the n-emitter region 15 of the high current gain long lifetime region 12. This causes the p-base - n-emitter junction at the long lifetime region 12 to become forward biased, initiating turn-on at that part of the device. The limiting resistances 9 and 17 ensure that current flow through the initially small turned-on area in the long lifetime region 12 is kept below damagingly high levels. The current flowing through the long lifetime region 12 then turns on the rest of the device via the auxiliary thyristor 8. Although only one long lifetime region has been shown, it may be advantageous to have a plurality of such regions distributed throughout the device.

The long carrier lifetime regions 12 and 13 are produced using well known processing techniques during manufacture of the thyristor. The semiconductor body on which the thyristor is formed initially has long carrier lifetimes throughout. During manufacture, a metal masking layer for example, is laid down on the thyristor surface over those areas which it is desired to leave with a long carrier lifetime. The body is then irradiated, for example, with a high energy (2-10 MeV) electron beam. The irradiation causes damage sites to be produced in unmasked parts of the substrate. The damage sites act as recombination centres and hence carrier lifetimes are reduced in the unmasked portion.

## Claims

1. A thyristor comprising a region of relatively long carrier lifetime (12) compared to that of a bulk conducting volume, the region being located within approximately four carrier diffusion lengths from the bulk conducting volume such that, during conduction, sufficient charge carriers enter the region from the bulk conducting volume, whereby under adverse turn-on conditions prior to the end of the thyristor recovery time, initial turn-on occurs at the region.

2. A thyristor as claimed in claim 1 and including an intermediate zone (13) of long carrier lifetime located between the region (12) and the bulk conducting volume.

3. A thyristor as claimed in claim 2 wherein the intermediate zone (13) is contiguous with the region (12) and located less than one carrier diffusion length from the bulk conducting volume.

4. A thyristor as claimed in claim 2 or 3 and including an auxiliary thyristor (8) located at the intermediate zone (13).

5. A thyristor as claimed in any preceding claim and wherein the region (12) is such that a smaller charge carrier density than that of the bulk conducting volume is required for turn-on to occur.

6. A thyristor as claimed in claim 5 and wherein the conduction path through the region (12) is shorter than that through the bulk conducting volume, whereby a high current gain is produced in the region.

7. A thyristor as claimed in claim 6 and wherein the region (12) is in a well configuration.

8. A thyristor as claimed in any preceding claim and wherein the current resulting from the initial turn-on at the region (12) is arranged to initiate turn-on at the bulk conducting volume via an amplifying gate.

9. A thyristor as claimed in any preceding claim and including a current limiting resistor (17) arranged adjacent to the region.

10. A thyristor as claimed in claim 9 and including a plurality of current limiting resistors (17) arranged to surround the region.

11. A thyristor as claimed in any preceding claim and including a plurality of regions (12) of relatively long carrier lifetime.

12. A thyristor as claimed in claim 11 and wherein the plurality of regions are arranged such that when turn-on occurs at one region, subsequent turn-on of the bulk conducting volume occurs substantially uniformly.

13. A thyristor as claimed in any preceding claim and wherein the relatively long carrier lifetime is approximately two or more times the carrier lifetime in the bulk conducting volume.

14. A method of manufacturing a thyristor as claimed in any preceding claim which includes masking part of a semiconductor body where it is desired to have a region of relatively long carrier lifetime by irradiating the semiconductor body with high energy electrons thereby producing a greater density of damage sites in the unmasked portion than in the masked part.

## Patentansprüche

1. Ein Thyristor mit einer Region relativ langer Trägerlebensdauer (12) im Vergleich zu derjenigen eines leitenden Massenvolumens, wobei sich die Region innerhalb näherungsweise vier Trägerdiffusionslängen von dem leitenden Massenvolumen befindet, so daß während der Leitung genügend Ladungsträger in die Region von dem leitenden Massenvolumen gelangen, wodurch unter ungünstigen Einschaltbedingungen vor dem Ende der Thyristor-Erholungszeit ein anfängliches Einschalten an der Region stattfindet.

2. Ein Thyristor wie in Anspruch 1 beansprucht,
mit einer Zwischenzone (13) langer Trägerlebensdauer, die zwischen der Region (12) und dem leitenden Massenvolumen angeordnet ist.

3. Ein Thyristor wie in Anspruch 2 beansprucht,
worin die Zwischenzone (13) an die Region (12) grenzt und weniger als eine Trägerdiffusionslänge von dem leitenden Massenvolumen entfernt angeordnet ist.

4. Ein Thyristor wie in Anspruch 2 oder 3 beansprucht,
mit einem Hilfsthyristor (8), der an der Zwischenzone (13) angeordnet ist.

5. Ein Thyristor wie in einem der vorhergehenden Ansprüche beansprucht,
worin die Region (12) derart ist, daß eine kleinere Ladungsträgerdichte als diejenige des leitenden Massenvolumens für ein Stattfinden des Einschaltens erforderlich ist.

6. Ein Thyristor wie in Anspruch 5 beansprucht,
worin der Leitungsweg durch die Region (12) kürzer ist als derjenige durch das leitende Massenvolumen, wodurch eine hohe Stromverstärkung in der Region erzeugt wird.

7. Ein Thyristor wie in Anspruch 6 beansprucht,
worin sich die Region (12) in einer Vertiefungskonfiguration befindet.

8. Ein Thyristor wie in einem der vorhergehenden Ansprüche beansprucht,
worin dafür gesorgt ist, daß der Strom, der aus dem anfänglichen Einschalten an der Region (12) resultiert, ein Einschalten an dem leitenden Massenvolumen über ein verstärkendes Gate initiiert.

9. Ein Thyristor wie in einem der vorhergehenden Ansprüche beansprucht,
mit einem Strombegrenzungswiderstand (17), der benachbart der Region angeordnet ist.

10. Ein Thyristor wie in Anspruch 9 beansprucht,
mit einer Vielzahl von Strombegrenzungswiderständen (17), die so angeordnet sind, daß sie die Region umgeben.

11. Ein Thyristor wie in einem der vorhergehenden Ansprüche beansprucht,
mit einer Vielzahl von Regionen (12) relativ langer Trägerlebensdauer.

12. Ein Thyristor wie in Anspruch 11 beansprucht,
worin die Vielzahl von Regionen so angeordnet ist, daß, wenn ein Einschalten an einer Region stattfindet, ein anschließendes Einschalten des leitenden Massenvolumens im wesentlichen gleichförmig stattfindet.

13. Ein Thyristor wie in einem der vorhergehenden Ansprüche beansprucht,
worin die relativ lange Trägerlebensdauer näherungsweise das zwei- oder mehrfache der Trägerlebensdauer in dem leitenden Massenvolumen beträgt.

14. Ein Verfahren zur Herstellung eines Thyristors wie in einem der vorhergehenden Ansprüche beansprucht,
welches den Schritt umfaßt,
daß ein Teil eines Halbleiterkörpers dort maskiert wird, wo das Vorliegen einer Region relativ langer Trägerlebensdauer erwünscht ist, indem der Halbleiterkörper mit Elektronen hoher Energie bestrahlt wird, wodurch eine größere Dichte von Schadensstellen in dem unmaskierten Abschnitt als in dem maskierten Teil erzeugt wird.

## Revendications

1. Thyristor comprenant une région présentant une durée de vie de porteurs relativement longue (12) par comparaison avec celle d'un volume de conduction dans la masse, la région étant située dans approximativement quatre longueurs de diffusion de porteurs par rapport au volume de conduction dans la masse de telle sorte que pendant une conduction, des porteurs de charge suffisants entrent dans la région depuis le volume de conduction dans la masse et ainsi, dans le cas de conditions de déblocage défavorables avant la fin du temps de restauration du thyristor, un déblocage initial se produit au niveau de la région.

2. Thyristor selon la revendication 1, incluant une zone intermédiaire (13) de durée de vie de porteurs longue située entre la région (12) et le volume de conduction dans la masse.

3. Thyristor selon la revendication 2, dans lequel la zone intermédiaire (13) est contiguë à la région (12) et est située à moins d'une longueur de diffusion de porteurs du volume de conduction dans la masse.

4. Thyristor selon la revendication 2 ou 3, incluant un thyristor auxiliaire (8) situé au niveau de la zone intermédiaire (13).

5. Thyristor selon l'une quelconque des revendications précédentes, dans lequel la région (12) est telle qu'une densité de porteurs de charge inférieure à celle du volume de conduction dans la masse est nécessaire pour qu'un déblocage se produise.

6. Thyristor selon la revendication 5, dans lequel la voie de conduction au travers de la région (12) est plus courte que celle au travers du volume de conduction dans la masse et ainsi, un gain de courant élevé est produit dans la région.

7. Thyristor selon la revendication 6, dans lequel la région (12) est selon une configuration de puits.

8. Thyristor selon l'une quelconque des revendications précédentes, dans lequel le courant résultant du déblocage initial au niveau de la région (12) est agencé pour initier un déblocage au niveau du volume de conduction dans la masse via une grille d'amplification.

9. Thyristor selon l'une quelconque des revendications précédentes, incluant une résistance de limitation de courant (17) agencée de manière à être adjacente à la région.

10. Thyristor selon la revendication 9, incluant une pluralité de résistances de limitation de courant (17) agencées de manière à entourer la région.

11. Thyristor selon l'une quelconque des revendications précédentes, incluant une pluralité de régions (12) présentant une durée de vie de porteurs relativement longue.

12. Thyristor selon la revendication 11, dans lequel la pluralité de régions sont agencées de telle sorte que lorsqu'un déblocage se produit au niveau d'une région, un déblocage suivant du volume de conduction dans la masse se produit sensiblement uniformément.

13. Thyristor selon l'une quelconque des revendications précédentes, dans lequel la durée de vie de porteurs relativement longue vaut approximativement deux fois ou plus la durée de vie de porteurs dans le volume de conduction dans la masse.

14. Procédé de fabrication d'un thyristor selon l'une quelconque des revendications précédentes, lequel inclut une partie de masquage d'un corps semiconducteur où l'on souhaite disposer d'une région de durée de vie de porteurs relativement longue en irradiant le corps semiconducteur à l'aide d'électrons haute énergie d'où ainsi la production d'une densité plus importante de sites d'endommagement dans la partie non masquée que dans la partie masquée.
